# EUROPEAN PATENT APPLICATION

(11) **EP 3 422 825 A1**
(43) Date of publication of application: **02.01.2019**
(21) Application number: 18179715.0
(22) Date of filing: 26.06.2018
(51) Int. Cl.: H05K 1/11, H05K 1/14, B60T 7/04, B60T 8/00

(54) **PRINTED CIRCUIT BOARD**

(30) Priority: 29.06.2017 JP 2017127017
(71) Applicant: Tyco Electronics Japan G.K., Takatsu-ku Kawasaki Kanagawa 213-8535 (JP)
(72) Inventor: Sato, Kenta, Kawasaki-shi, Kanagawa 213-8535 (JP); Jeong, Heewon, Kawasaki-shi, Kanagawa 213-8535 (JP)
(74) Representative: Johnstone, Douglas Ian

(57) **Abstract**

A printed circuit board (54) is provided with a board main body (54A) with a stroke sensor or magnetic sensing device (70) on at least one of top and bottom faces, an external connection pad (63) provided on a top face (54F) opposite to a bottom face (54B) on which the stroke sensor (70) is mounted, and through-holes (60A, 60B, 60C, 60D) so formed as to extend through the board main body (54A) for electrically connecting the stroke sensor (70) and the external connection pad (63). The external connection pad (63) is provided for each of the plurality of through-holes (60A, 60B, 60C, 60D), and the plurality of external connection pads (63) are electrically independent. The printed circuit board (54) is capable of undergoing, for example, electrical processing for writing a grogram, and/or undergoing an inspection to ascertain whether it properly operates, before it is loaded onto or into electronic equipment.

## Description

### Technical Field

The present invention relates to a printed circuit board capable of being programmed and/or inspected before it is installed in electronic equipment.

### Background Art

Much electronic equipment is provided with a printed circuit board on which an IC (Integrated Circuit) chip, a capacitor, and the like, are provided. As an example of this, a printed circuit board described in JP2003-008184A is known. JP2003-008184A discloses a printed circuit board provided with a first pair of pads provided at a predetermined interval and a second pair of additional pads provided between the respective first pads. The second pair of additional pads allow excessive solder overflowing from the first pair of pads to adhere thereto, thereby preventing a solder ball from being formed.

### Prior Art

Patent JP2003-008184A discloses prior art electronic equipment with a printed circuit board.

### Technical Problem

A printed circuit board is required to undergo processing for writing a program required for operation to the IC chip, and/or to undergo an inspection to ascertain whether it operates properly. Conventionally, such an inspection is performed after a printed circuit board is loaded into a housing, such as a package, and therefore, when the printed circuit board is found to be defective, it has to be discarded together with the housing. This is wasteful, and consequently increases costs.

In view of these circumstances, it is an object of the present invention to provide a printed circuit board capable of undergoing electrical processing for writing a program, for example, and/or an inspection to ascertain whether it operates properly, even before being loaded in electronic equipment.

### Solution to Problems

A printed circuit board of the present invention is provided with a board main body having a magnetic sensing device mounted on at least one of top and bottom faces; an external connection pad provided on the other face opposite to the face on which the magnetic sensing device is mounted; and a hollow-structured electrical conductor so formed as to extend through the board main body for electrically connecting the magnetic sensing device to the external connection pad. According to the printed circuit board of the present invention, before being loaded onto/into electronic equipment, the printed circuit board can undergo necessary processing, such as writing of a program, for example, with an external terminal brought into contact with the external connection pad, and can undergo a predetermined inspection with an external terminal of an inspection device brought into contact with the external connection pad. Therefore, when the printed circuit board fails the inspection, such work as removal thereof from the electronic equipment is not required.

In a case where the board main body in the present invention is provided with the hollow-structured electrical conductor including a plurality of hollow-structured electrical conductors, the external connection pad can be provided for each of the plurality of hollow-structured electrical conductors, and the plurality of external connection pads can be made electrically independent. Therefore, according to the printed circuit board of the present invention, it is possible to select a suitable one from the external connection pads and bring the external terminal into contact therewith in order to perform necessary processing, including an inspection.

In the printed circuit board of the present invention, the plurality of hollow-structured electrical conductors can be formed along a peripheral edge of the board main body. Therefore, according to the printed circuit board of the present invention, even when external terminals are required to be brought into contact with the plurality of external connection pads in order to perform necessary processing, including an inspection, the external terminals can avoid interfering with each other. As a typical example, the plurality of hollow-structured electrical conductors can be formed at or near four corners of the board main body.

It is preferred that the board main body of the present invention be provided with a flat suction face formed over a predetermined area on the other face on which the external connection pad is formed. Therefore, according to the printed circuit board of the present invention, when the printed circuit board is handled by air suction, the suction can be used to reliably secure the printed circuit board.

The board main body can be provided with a locating region corresponding to an external locating guide. Therefore, according to the printed circuit board of the present invention, the printed circuit board can easily be located by fitting the locating guide and the locating region together.

### Advantageous Effects of Invention

According to the printed circuit board of the present invention, before being loaded onto/into electronic equipment, the printed circuit board can undergo necessary processing, such as writing of a program, for example, with an external terminal brought into contact with the external connection pad, and can undergo a predetermined inspection with an external terminal of an inspection device brought into contact with the external connection pad. When the printed circuit board fails the inspection, such work as removal thereof from the electronic equipment is not required.

### Brief Description of Drawings

Figure 1 is a cross-sectional view showing an input device in a brake system provided with a brake control unit equipped with a printed circuit board according to an embodiment of the present invention;
Figure 2 is an isometric view showing the control unit in the input device of Figure. 1, with a main board and a sensor board detached;
Figure 3 is an isometric view showing the control unit in the input device of Figure. 1, with the sensor board loaded in an accommodation region;
Figure 4 is an isometric view showing the control unit in the input device of Figure. 1, with the main board loaded;
Figures 5(a) to 5(c) are top views showing some forms of the sensor board in the present embodiment, as viewed from a bottom face of the sensor board;
Figures 6(a) to 6(c) are top views showing some forms of the sensor board in the present embodiment, as viewed from the top face of the sensor board; and
Figure 7 is a partially-enlarged view of Figure 1.

### Description of Embodiments

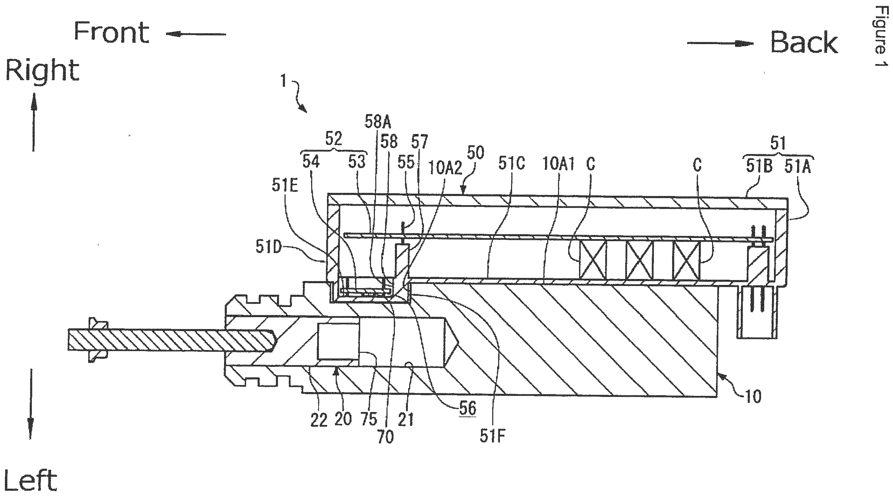

Hereinafter, with reference to the accompanying drawings, an embodiment of the present invention will be described. The present embodiment will be described with reference to an example of using the same for a brake control unit 50, where a printed circuit board of the present invention is applied to an input device 1 included in a brake system for a vehicle for generating brake fluid pressure according to a manipulated variable of a brake pedal (not shown). The input device 1, as shown in Figure 1, is provided with a base 10 being a substantially-rectangular-parallelepiped-like enclosure made of a non-magnetic metal material, a master cylinder 20 for generating brake fluid pressure by brake pedal force, and the brake control unit 50. The brake control unit 50 controls the operation of a motor (not shown) for driving a motor cylinder (not shown) for generating brake fluid pressure, on the basis of information obtained from a stroke sensor 70 and/or a pre-stored program or the like. It should be noted that directions, such as top and back or right and left, in the following description are used for convenience in order to describe the input device 1, and they generally correspond to directions when the input device 1 is loaded in a vehicle. The terms should not be considered to limit the invention in any way as other orientations could be used.

The master cylinder 20, as shown in Figure 1, is provided with a piston 22 inserted into a cylinder cavity 21 of the base 10, and a permanent magnet 75 provided as a sensed member at a distal end thereof.

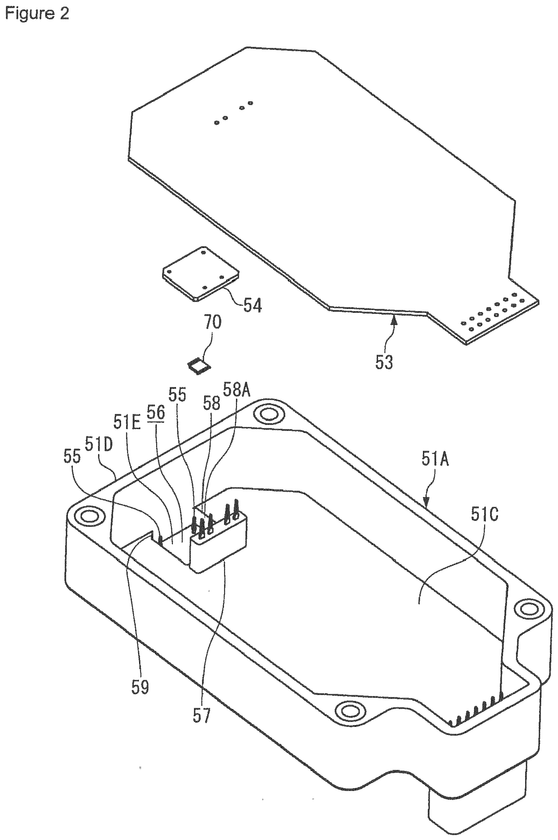

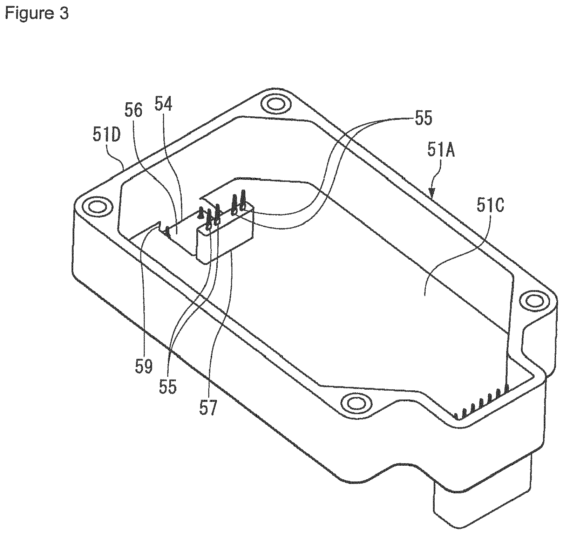

The brake control unit 50, as shown in Figures 1 and 2, has a housing 51 being a resin enclosure attached to a right side face or top side face 10A1 of the base 10 of the brake system for a vehicle. The housing 51, as shown in Figure 1, accommodates a control board 52 in its internal space. The housing 51 is provided with a sensor accommodating portion 51F protruding leftward from a face opposite the base 10. Inside the sensor accommodating portion 51F, an accommodating recess 58 communicating with the internal space of the housing 51 is formed. In the accommodating recess 58, a sensor board 54 and the stroke sensor 70 are accommodated. It should be noted that the housing 51 contains a device, such as a coil C, positioned therein, which is omitted in Figures 2 and 3.

The housing 51, as shown in Figure 1, is provided with a main body 51A for accommodating the control board 52 therein, and a lid 51B for closing an opening of the main body 51A. The main body 51A is a member in the shape of an open-topped box, and is integrally formed by injection molding of an electrically-insulating resin. In addition, a connection terminal 55 for making an electrical connection between the main board 53 and the sensor board 54 of the control board 52 is accommodated in the main body 51A. As shown in Figure 2, a portion provided for the connection is protrudes into an accommodating region 56. The connection terminal 55 is insert-molded integrally when the main body 51A is produced by injection molding.

The main body 51A, as shown in Figures 1 and 2, is provided with the accommodating region 56 for accommodating the sensor board 54. The accommodating region 56 is a substantially-rectangular-parallelepiped-like space enclosed with an inner peripheral face 58A of the accommodating recess 58 opened in a bottom face 51C near a side wall 51D. The accommodating region 56 has an opening area allowing the sensor board 54 to be accommodated with a suitable gap therearound. In addition, a bottom floor 51E inside the accommodating region 56 is located closer to the master cylinder 20 than the bottom face 51C of the main body 51A.

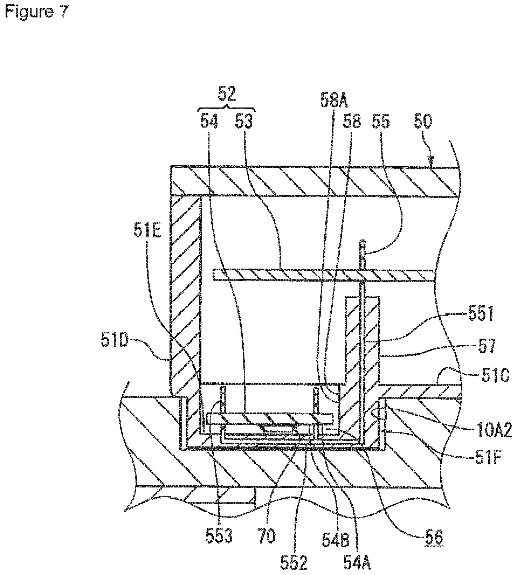

The connection terminal 55 is provided within and beyond the accommodating region 56. The connection terminal 55 is formed of a metal material having excellent conductivity, for example, copper or a copper alloy. In addition, the connection terminal 55, as shown in Figure 7, has an L shape on the whole, and is provided with a first connection portion 551 vertical or perpendicular to the bottom face 51C outside the accommodating region 56, a buried portion 552 extending from the first connection portion 551 and being parallel to the bottom floor 51E, and a second connection portion 553 extending from the buried portion 552 and rising vertically or perpendicularly from the bottom floor 51E. The first connection portion 551 extends through a partition 57 rising at a boundary between the accommodating recess 58 and the bottom face 51C. The first connection portion 551 and the second connection portion 533 are each provided with an eye-of-needle type press-fit terminal element at their respective distal ends in order to provide a stable electrical connection with the main board 53 and the sensor board 54, respectively.

The connection terminal 55, as shown in Figure 7, has the second connection portion 553 rising from the bottom floor 51E, and the distal end portion thereof is exposed inside the accommodating region 56. The connection terminal 55 has the first connection portion 551 electrically connected with the main board 53, and has the second connection portion 553 electrically connected with the sensor board 54. That is, the main board 53 and the sensor board 54 are electrically connected via the connection terminal 55, so that electric power is supplied from the main board 53 to the sensor board 54 via the connection terminal 55 and, in addition, a sensing signal of the stroke sensor (magnetic sensing device) 70 is inputted from the sensor board 54 to the main board 53 via the connection terminal 55.

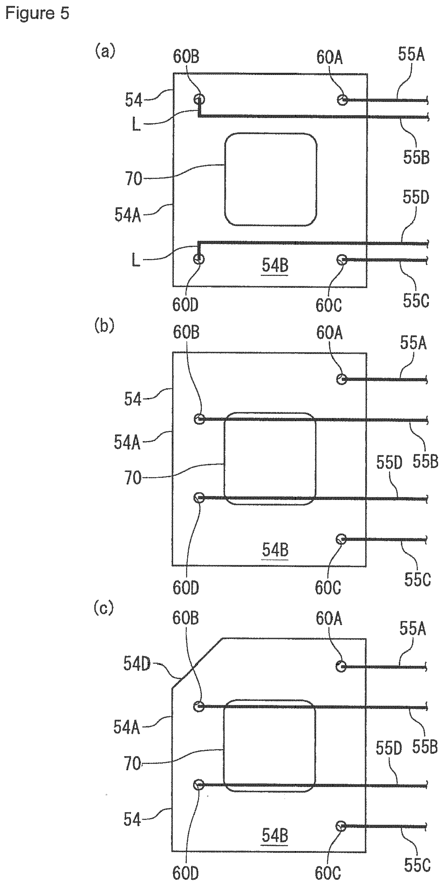

The present embodiment uses four connection terminals 55, two of which are exposed in the accommodating region 56 near the side wall 51D, and the remaining two of which are exposed in the accommodating region 56 far from the side wall 51D. As shown in Figure 5(a), four connection terminals 55A, 55B, 55C, 55D are press-fitted into through-holes 60A, 60B, 60C, 60D forming hollow-structured electrical conductors provided at four corners of the sensor board 54, thereby mechanically supporting the sensor board 54 while the main board 53 and the sensor board 54 are electrically connected. The through holes 60A, 60B, 60C, 60D may comprise plated through-holes. It should be noted that the connection terminal 55 is written as connection terminals 55A, 55B, 55C, 55D when they need to be distinguished, or they are collectively referred to as connection terminal 55 when they do not need to be distinguished.

The accommodating region 56 has a region between the sensor board 54 and the bottom floor 51E of the accommodating region 56 shielded from outside to such an extent as to avoid receiving a foreign airborne matter from outside, since the sensor board 54 is supported with the connection terminals 55 inside the accommodating region 56, as shown in Figures 1 and 3. Therefore, the stroke sensor 70 mounted on the sensor board 54 positioned in this region avoids receiving a foreign airborne matter from outside.

Next, the control board 52, as shown in Figures 1 and 2, is composed of the main board 53 and the sensor board 54 arranged hierarchically or lower relative to the main board 53, and the stroke sensor 70 is mounted on the sensor board 54. The sensor board 54 is positioned between the main board 53 and the bottom floor 51E of the accommodating region 56, and positioned closer to the main body 51A (bottom floor 51E) of the housing 51.

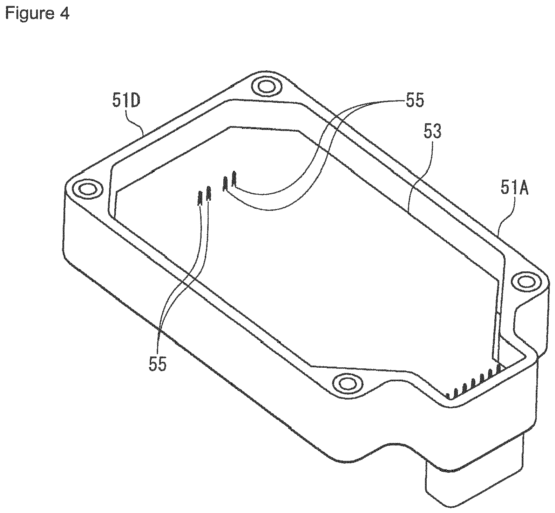

The main board 53, as shown in Figures 1 and 4, is supported with the connection terminal 55 in the internal space of the housing 51. The main board 53 receives an input of information on running conditions fed from the vehicle in addition to a sensed value fed from the stroke sensor 70, and controls each actuator (not shown) of a fluid pressure control device (not shown) for supporting stabilization of behavior of the vehicle on the basis of a stored program. Specifically, the main board 53 controls opening and closing operation of a solenoid valve (not shown) for switching the communication state of an oil path, and/or the number of revolutions of a motor (not shown) for driving a motor cylinder (not shown) for generating brake fluid pressure.

The sensor board 54, as shown in Figure 7, is mounted with the stroke sensor 70 on a bottom face 54B of a board main body 54A and inside the sensor accommodating portion 51F inserted into a groove 10A2 formed in the right side face or top side face 10A1. The stroke sensor 70, as shown in Figure 1, is positioned opposite the permanent magnet 75 of the master cylinder 20, facing the permanent magnet 75 across the base 10 and the peripheral wall of the piston 22. Thereby, the stroke sensor 70 is positioned at a shortest distance from or close to the permanent magnet 75 in the housing 51, and senses forward/backward movement of the permanent magnet 75, thereby sensing a sliding stroke of the piston 22.

The sensor board 54, as shown in Figure 5(a), has the through-holes 60A, 60B, 60C, 60D formed in the vicinity of the four corners for being press-fitted with the connection terminals 55A, 55B, 55C, 55D. By providing an electrode (not shown) to an inner periphery of each of the through holes 60A to 60D, a hollow-structured electrical conductor is formed. The hollow-structured electrical conductor is electrically connected with the stroke sensor 70 via a wiring pattern omitted in the drawings. The four through-holes 60A to 60D, in this example, are positioned in the vicinity of vertices of the rectangle. The connection terminals 55A, 55B connected to the two through-holes 60A, 60B arranged in a rightward/leftward direction in Figure 5(a) are prevented from interfering with each other. That is, the connection terminal 55A extends straight in a planar direction, whereas the connection terminal 55B is so bent in an L-shape near the through-hole 60B as to circumvent the connection terminal 55A. The same applies to the connection terminals 55C, 55D connected to the through-holes 60C, 60D.

Figure 5(b) shows an example of avoiding interference between the connection terminal 55A and the connection terminal 55B and between the connection terminal 55C and the connection terminal 55D and dispensing with bending of the connection terminals 55B, 55D. That is, an interval between the two through-holes 60A, 60C arranged along one of opposite two sides is made larger than an interval between the two through-holes 60B, 60D arranged along the other of the opposite two sides. This causes the positions of the through-holes 60A, 60B arranged in an extending direction of the connection terminals 55A, 55B to be out of alignment, and causes the positions of the through-holes 60C, 60D arranged in an extending direction of the connection terminals 55C, 55D to be out of alignment, and therefore all of the connection terminals 55A, 55B, 55C, 55D can be uniformly formed into a shape extending straight in the planar direction.

Next, the sensor board 54 shown in Figure 5(c) has a shape for enabling the connection terminals 55A, 55B, 55C, 55D to be press-fitted into the sensor board 54 without making a mistake in the orientation thereof, that is, the sensor board 54 is formed into an asymmetrical planar shape by providing a chamfer 54D at one corner of the sensor board 54. On the other hand, in order to make similar a planar shape of the accommodating region 56 defined by the inner peripheral face 58A of the accommodating recess 58 to the planar shape of the sensor board 54, an abutting face 59 for abutting on the chamfer 54D of the sensor board 54 is provided by filling in one corner of the inner peripheral face 58A of the accommodating recess 58 in a triangular shape, as shown in Figure 2. Thereby, it is made possible to visually confirm that the orientation of the sensor board 54 is correct when the chamfer 54D at the one corner of the sensor board 54 and the abutting face 59 provided on the inner peripheral face 58A of the accommodating region 56 conform to each other, and it is made impossible to press-fit the connection terminal 55 into the sensor board 54 with a wrong orientation thereof.

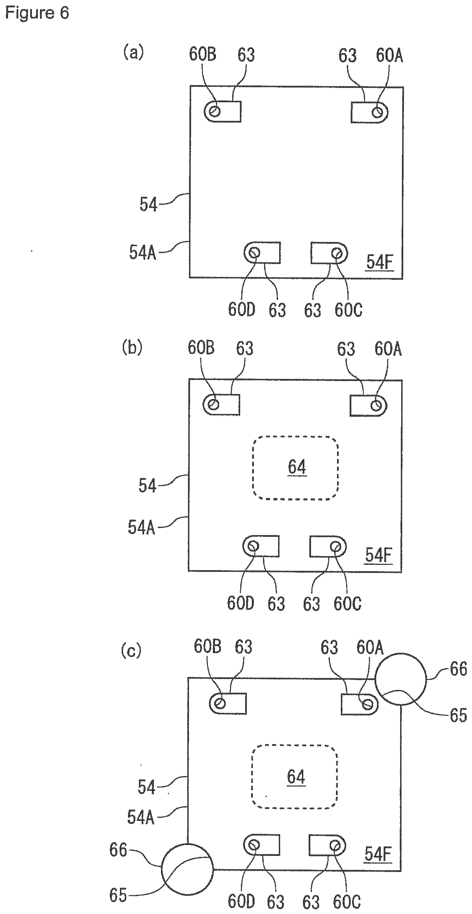

Before being installed in the brake control unit 50, the sensor board 54 undergoes an inspection to ascertain whether or not the sensor board 54 operates properly in addition to programming the stroke sensor 70 of the sensor board 54. Conveniently, when carrying out this process, as shown in Figure 6(a), an external connection pad 63 is provided around each of the through-holes 60A to 60D. The external connection pad 63 is made of a conductive metal material, electrically connected to the electrode provided on the inner periphery of each of the through-holes 60A to 60D, and led out to a predetermined position on a top face 54F of the board main body 54A. It should be noted that the stroke sensor 70 is provided on the bottom face 54B of the board main body 54A, while the external connection pads 63 are provided on the top face 54F where a mounted component, such as the stroke sensor 70 of the sensor board 54, is not provided. In order to perform processing, such as teaching or programming, the stroke sensor 70 of the sensor board 54, a terminal of a device for performing programming or the like is brought into contact with the external connection pads 63 to exchange necessary information exchanged between the stroke sensor 70 and the device.

Figure 6(b) shows a preferred form of the sensor board 54 taking handling into consideration. This sensor board 54 is adapted for transportation of the sensor board 54 by air suction, and is provided with a suction face 64 comprising a flat face for being subjected to air suction in the top face 54F. The stroke sensor 70 and the wiring pattern for connecting the stroke sensor 70 and the electrodes are not provided on the suction face 64. For example, by providing all elements, such as the stroke sensor 70 and the electrodes, on the bottom face of the sensor board 54, the suction face 64 can be provided on the top face 54F. In addition, with the suction face 64 provided on the top face 54F, the stroke sensor 70 and the wiring pattern or the like can also be so provided on the top face 54F as to avoid the suction face 64.

Figure 6(c) shows a form of sensor board 54 which can be advantageously retained at a fixed position during teaching or programming. The sensor board 54 has circular-arc-like locating regions 65, 65 formed by cutting out two corners located diagonally. During programming, by fitting the locating regions 65, 65 to circular-cylindrical locating guides 66, 66 that fit tightly or in a form fitting manner into the locating regions 65, 65, the sensor board 54 can be retained at the fixed position. It should be noted that, though the plurality of locating guides 66, 66 and the plurality of locating regions 65, 65 have been shown here by way of example, a single locating guide 66 and a single locating region 65 may be provided.

It should be noted that the main board 53 is positioned at an interval from or spaced from the right side face or top side face 10A1 of the base 10 and, as shown in Figure 1, the coil C or the like is positioned in a space created by the interval. The sensor board 54 is positioned utilizing such a space for positioning the coil C or the like. In addition, though the stroke sensor 70, in Figure 1, is shown being proximate to the right side face or the top side face 10A1 of the base 10, a predetermined gap may be provided between the stroke sensor 70 and the right side face or top side face 10A1. In addition, although the stroke sensor 70 is shown being opposite the permanent magnet 75 across the base 10 and the peripheral wall of the piston 22, the stroke sensor 70 is not limited thereto, but may not be opposite the permanent magnet 75 in an initial position of the master cylinder 20 when the brake pedal is not stepped on.

### Advantageous Effects of the present embodiment

The sensor board 54 of the present embodiment described above achieves the following advantageous effects. The sensor board 54 is provided with the external connection pads 63 provided on the other face, namely, the top face 54F, on which the stroke sensor 70 that is a mounted component is not loaded, and electrically connected to the hollow-structured electrical conductors including the through-holes 60A to 60D. Therefore, before the sensor board 54 is press-fitted to the connection terminals 55 of the housing 51 and thus loaded, teaching or programming can be performed with the terminal(s) of the teaching or programming device brought into contact with the external connection pads 63, and a predetermined inspection can easily be performed with a terminal of an inspection device brought into contact with the external connection pads 63. Even when the sensor board 54 fails the inspection, such work as removing the sensor board 54 from the housing 51 of the brake control unit 50 is not required.

In addition, the sensor board 54 is provided with the plurality (four) of through-holes 60A to 60D, and an external connection pad 63 is provided for each of the four through-holes 60A to 60D, and moreover, the four external connection pads 63 are electrically independent. Therefore, it is possible to select a suitable one from the external connection pads 63 and bring the external terminal into contact therewith to perform necessary processing, including an inspection.

The sensor board 54 has the four through-holes 60A to 60D formed along a peripheral edge thereof. Therefore, even when external terminals are required to be brought into contact with the plurality of external connection pads 63 in order to perform necessary processing, including an inspection, the external terminals can avoid interfering with each other. In addition, since the four through-holes 60A to 60D are formed at the four corners of the sensor board 54, the sensor board 54 is supported at four points by press-fitting the connection terminals 55A, 55B, 55C, 55D into the through-holes 60A, 60B, 60C, 60D, respectively. Therefore, a means for supporting the sensor board 54, for example, screw clamping or thermal bonding, is not required.

In addition, the sensor board 54 is provided with the flat suction face 64 over a predetermined area on a face (the other face) where the external connection pads 63 are formed. Therefore, when the sensor board 54 is handled by air suction toward the connection terminals 55, the suction connection can be reliably secured.

In addition, since the sensor board 54 is provided with the locating regions 65, 65 corresponding to the locating guides 66, 66, the sensor board 54 can easily be located by fitting the locating guides 66, 66 into the locating regions 65, 65.

Although a preferred embodiment of the present invention has been described above, the present invention is not limited to this embodiment, but can be modified properly within the scope thereof.

Although the embodiment described above shows an example where four identical external connection pads 63 are provided, the number of external connection pads in the present invention is not limited and, in addition, the shapes and/or dimensions of the plurality of external connection pads may be different from those described above.

In addition, although the embodiment described above shows an example, as a preferred form, where the suction face 64 is provided on the top face 54F of the board main body 54A on which a Hall IC is not provided, the present invention allows the suction face 64 to be provided on a face on which a mounted component, such as a Hall IC, is provided. This form requires the suction face 64 to be so provided as to avoid a region where such a mounted component is mounted, and therefore, normally, the suction face 64 is provided at a marginal portion out of the center of the sensor board 54.

### Reference Signs List

10...base
10A1...top side face
10A2...groove
20...master cylinder
21...cyclinder cavity
22...piston
50...brake control unit
51...housing
51A...main body
51B...lid
51C...bottom face
51D...side wall
51E...bottom floor
51F...sensor accommodating portion
52...control board
53...main board
54...sensor board
54A...board main body
54B...bottom face
54D...chamfer
54F...top face
55...connection terminals
55A, 55B, 55C, 55D...connection terminal
56...accommodating region
57...partition
58...accommodating recess
58A...inner peripheral face
59...abutting face
60A, 60B, 60C, 60D...through-hole/hollow structured electrical conductors
63...external connection pad
64...suction face
65...locating region
66...locating guide
70...stroke sensor
75...permanent magnet
551...first connection portion
552...buried portion
553 second connection portion
C...coil

## Claims

1. A printed circuit board (54) comprising:
a board main body (54A) having a magnetic sensing device (70) mounted on at least one of top and bottom faces;
an external connection pad (63) provided on the other face opposite to the face on which the magnetic sensing device (70) is mounted; and
a hollow-structured electrical conductor (60A, 60B, 60C, 60D) so formed as to extend through the board main body for electrically connecting the magnetic sensing device (70) to the external connection pad (63).

2. The printed circuit board (54) according to claim 1, wherein
the board main body (54A) comprises the hollow-structured electrical conductor comprising a plurality of hollow-structured electrical conductors (60A, 60B, 60C, 60D),
the external connection pad (63) is provided for each of the plurality of hollow-structured electrical conductors (60A, 60B, 60C, 60D), and
the plurality of external connection pads (63) are electrically independent.

3. The printed circuit board (54) according to claim 1 or 2, wherein
the plurality of hollow-structured electrical conductors (60A, 60B, 60C, 60D) are formed along a peripheral edge of the board main body (54A).

4. The printed circuit board according to any one of claims 1 to 3, wherein
the plurality of hollow-structured electrical conductors (60A, 60B, 60C, 60D) are formed at or near four corners of the board main body (54A).

5. The printed circuit board according to any one of claims 1 to 4, wherein
the board main body (54A) comprises a flat suction face (64) formed over a predetermined area on the other said face on which the external connection pad (63) is formed.

6. The printed circuit board (54) according to any one of claims 1 or 5, wherein
the board main body (54A)comprises a locating region (65) corresponding to an external locating guide (66).

7. The printed circuit board (54) according to any one of claims 1 to 6 wherein each hollow-structured electrical conductor (60A, 60B, 60C, 60D) comprises a through hole.

8. The printed circuit board (54) according to claim 7 wherein each hollow-structured electrical conductor (60A, 60B, 60C, 60D) comprises a plated through-hole.
